# EUROPÄISCHE PATENTSCHRIFT

(11) **EP 3 619 747 B1**
(45) Veröffentlichungstag und Bekanntmachung des Hinweises auf die Patenterteilung: **14.06.2023**
(21) Anmeldenummer: 18717211.9
(22) Anmeldetag: 08.03.2018
(51) Int. Cl.: H01L 31/167, H01L 31/0304, H03K 17/78, H03K 19/14, G02F 3/00

(54) **LICHTEMPFANGSEINHEIT**
LIGHT RECEIVING UNIT
UNITÉ DE RÉCEPTION DE LUMIÈRE

(30) Priorität: 02.05.2017 DE 102017004149
(43) Veröffentlichungstag der Anmeldung: 11.03.2020
(73) Patentinhaber: AZUR SPACE Solar Power GmbH, 74072 Heilbronn (DE)
(72) Erfinder: LAUERMANN, Thomas, 74076 Heilbronn (DE); PEPER, Christoph, 30173 Hannover (DE); KÖSTLER, Wolfgang, 74074 Heilbronn (DE)
(74) Vertreter: Koch Müller Patentanwaltsgesellschaft mbH
(86) Internationale Anmeldenummer: PCT/EP2018/000092
(87) Internationale Veröffentlichungsnummer: WO 2018/202323

(56) Entgegenhaltungen:
- EP-A1- 3 104 422
- WO-A1-2016/112204
- WO-A1-2017/067632
- WO-A1-2017/137150
- US-A- 5 113 076
- US-A- 6 043 550
- KAZUTOSHI NAKAJIMA ET AL: "A RAPID OPTOELECTRONIC HALF-ADDER LOGIC COMPOSED OF A PAIR OF GAAS METAL-SEMICONDUCTOR-METAL PHOTODETECTORS", IEEE JOURNAL OF QUANTUM ELECTRONICS, IEEE SERVICE CENTER, PISCATAWAY, NJ, USA, Bd. 26, Nr. 4, April 1990 (1990-04), Seiten 619-621, XP000149712, ISSN: 0018-9197, DOI: 10.1109/3.53375

## Beschreibung

Die Erfindung betrifft eine Lichtempfangseinheit sowie einen die Lichtempfangseinheit umfassenden Optokoppler.

Lichtempfangseinheiten sind hinlänglich bekannt. In einem Optokoppler wird eine Lichtempfangseinheit mit einer Sendeeinheit kombiniert, wobei die beiden Einheiten galvanisch getrennt, jedoch optisch gekoppelt sind. Derartige Bauelemente sind aus der US 4 996 577 bekannt. Auch aus der US 2006 /0048811 A1, der US 8 350 208 B1 und der WO 2013/067969 A1 sind optische Bauelemente bekannt.

In der DE 2 310 053 A1 wird ein Feld aus lichtemittierenden Elementen und aus lichtempfangenden Elementen als Lichtempfangseinheit in logischer Anordnung beschrieben. Eine Lichtempfangseinheit mit zwei Empfangsdioden ist aus deutschen Patentanmeldung Nr. 10 2016 001 388.5 bekannt.

Weitere Lichtempfangseinheiten mit mehreren Halbleiterdioden sind aus der US 6,043,550 A, der US 5,113,076 A, der WO 2017/067632 A1, der EP 3 104 422 A1, der WO 2016 / 112204 A1 sowie aus "A Rapid Otoelectronic Half-Adder Logic Composed of a Pair of GaAs Metal-Semiconductor-Metal Photodetectors", Kazutoshi Nakajima et al., IEEE Journal of Quantum Electronics, IEEE Service Center Piscataway, NJ, USA, Bd. 26, Nr. 4, April 1990, Seiten 619-621, XP000149712, ISSN:0018-9197, DOI: 10.1109/3.53375 ist ein Logik-Gate mit zwei Photodetektoren bekannt.

Aus der US 4 127 862, der US 5 239 354 B1, der DE 10 2010 001 420 A1, aus Nader M. Kalkhoran, et al, "Cobalt disilicide intercell ohmic contacts for multijunction photovoltaic energy converters", Appl. Phys. Lett. 64, 1980 (1994) und aus A. Bett et al, "III-V Solar cells under monochromatic illumination", Photovoltaic Specialists Conference, 2008, PVSC '08. 33rd IEEE, Seite 1-5, ISBN:978-1-4244-1640-0 sind skalierbare Spannungsquellen oder auch Solarzellen aus III-V Materialien bekannt.

Vor diesem Hintergrund besteht die Aufgabe der Erfindung darin, eine Vorrichtung anzugeben, die den Stand der Technik weiterbildet.

Die Aufgabe wird durch eine Lichtempfangseinheit mit den Merkmalen des Patentanspruchs 1 sowie einen die Empfangseinheit umfassenden Optokoppler gemäß Anspruch 8 gelöst. Vorteilhafte Ausgestaltungen der Erfindung sind Gegenstand von Unteransprüchen.

Gemäß dem Gegenstand der Erfindung weist eine Lichtempfangseinheit eine erste Energiequelle auf.

Die erste Energiequelle weist zwei, jeweils als Stromquelle oder als Spannungsquelle ausgebildeten Teilquellen auf, wobei die erste Energiequelle lediglich einen ersten elektrischen Anschlusskontakt und einen zweiten elektrischen Anschlusskontakt aufweist. Der erster Anschlusskontakt ist an der Oberseite der ersten Teilquelle und der zweiter Anschlusskontakt an der Unterseite der zweiten Teilquelle ausgebildet.

Die erste Teilquelle weist mindestens eine erste Halbleiterdiode und die zweite Teilquelle mindestens eine zweite Halbleiterdiode auf.

Die erste Halbleiterdiode weist eine an eine erste Lichtwellenlänge angepasste Absorptionskante und die zweite Halbleiterdiode weist eine an eine zweite Lichtwellenlänge angepasste Absorptionskante auf, so dass die erste Teilquelle bei Bestrahlung mit der ersten Lichtwellenlänge und die zweite Teilquelle bei Bestrahlung mit der zweiten Lichtwellenlänge elektrische Spannung erzeugen.

Die erste Lichtwellenlänge ist von der zweiten Lichtwellenlänge um eine Differenzwellenlänge verschieden.

Die erste Halbleiterdiode ist zu der zweiten Halbleiterdiode entgegengesetzt gepolt in Reihe d.h. antiseriell geschaltet, so dass sich die von der ersten Halbleiterdiode und die von der zweiten Halbleiterdiode erzeugten Spannungen zumindest teilweise kompensieren.

Es sei angemerkt, dass unter der Bezeichnung Lichtwellenlänge, wobei insbesondere das Licht einer LED gemeint ist, die Zentralwellenlänge eines im Allgemeinen Gauß-förmigen Spektrums gemeint ist, welches beispielsweise bei einer typischen 850 nm-LED eine Halbwertsbreite von 20-30 nm aufweist.

Auch versteht es sich, dass die der Lichtwellenlänge entsprechende Photonenenergie etwas größer oder gleich der Bandlückenenergie der Absorptionsschichten der Halbleiterdioden ist.

Des Weiteren sei angemerkt, dass der Unterschied, d.h. die Differenzwellenlänge zwischen der ersten Lichtwellenlänge und der zweiten Lichtwellenlänge wenigstens 40 nm beträgt.

Des Weiteren sei angemerkt, dass im Unterschied zu dem Stand der Technik sich in vorteilhafter Weise mit dem vorliegenden Stapelansatz Quellenspannungen der einzelnen Teilquellen oberhalb von 2V bzw. von bis zu 5V erzeugen lassen.

Es zeigte sich, dass durch eine Hintereinanderschaltung von mehreren Halbleiterdioden zu einer Teilquelle sich die Quellenspannungen der Halbleiterdioden in erster Näherung addieren. Vorzugsweise liegt die Anzahl N der in Serie geschalteten Halbleiterdioden kleiner als zehn.

Ein Vorteil der erfindungsgemäßen Vorrichtung ist es, dass sich durch die entgegengesetzte Polung der in Reihe geschalteten Teilquellen auf besonders einfache und zuverlässige Weise eine XOR Verknüpfung, also ein exklusives ODER mittels zwei optischen Signalen, nämlich der ersten und der zweiten Wellenlänge L1 und L2, nachbilden lässt.

Die Empfangseinheit weist hierbei lediglich zwei elektrische Anschlüsse auf. Ein weiterer Vorteil ist, dass sich mittels der stapelförmigen Anordnung der Halbleiterdioden im Vergleich zu der bisherigen lateralen Anordnung mit Siliziumdioden eine große Flächeneinsparung ergibt und eine kompakte Bauweise möglich ist. Eine XOR Verknüpfung eignet sich insbesondere für Schutzschaltungen für Leistungstransistoren.

In einer Weiterbildung weist jede Teilquelle mehrere Halbleiterschichten auf, wobei die Halbleiterschichten für jede Teilquelle stapelförmig angeordnet sind und jede Teilquelle eine Oberseite und eine Unterseite aufweist.

Die Unterseite der ersten Teilquelle ist auf der Oberseite der zweiten Teilquelle angeordnet.

Die erste Teilspannungsquelle und die zweite Teilspannungsquelle sind monolithisch integriert, so dass die beiden Teilquellen einen gemeinsamen Stapel mit einer Vorderseite und einer Rückseite ausbilden.

Es versteht sich, dass vorzugsweise die gesamte Oberseite des Stapel mit Licht der ersten Lichtwellenlänge und / oder mit Licht der zweiten Lichtwel lenlänge bestrahlt wird.

Gemäß einer anderen Weiterbildung weist die Lichtempfangseinheit einen ersten selbstsperrenden Transistor auf, wobei der erste Anschlusskontakt der ersten Energiequelle mit dem Gate-Anschluss des ersten Transistors und der zweite Anschlusskontakt der ersten Energiequelle mit dem Source-Anschluss des ersten Transistors verschaltet ist.

In einer alternativen Ausführungsform weist die Lichtempfangseinheit eine zweite Energiequelle auf, wobei die zweite Energiequelle im Wesentlichen baugleich mit der der ersten Energiequelle ausgebildet ist.

Gemäß einer weiteren Ausführungsform ist zwischen der ersten Energiequelle und der zweiten Energiequelle eine elektrisch isolierende Barriere angeordnet.

In einer Weiterbildung weist die Lichtempfangseinheit einen ersten selbstsperrenden Transistor und einen zweiten selbstsperrenden Transistor aufweist, wobei der erste Transistor als n-Kanal-Transistor ausgebildet ist und der zweite Transistor als p-Kanal Transistor ausgebildet ist.

Der erste Anschlusskontakt der ersten Energiequelle ist mit dem Gate-Anschluss des ersten Transistors und der zweite Anschlusskontakt der ersten Energiequelle mit dem Source-Anschluss des ersten Transistors verschaltet.

Der erste Anschlusskontakt der zweiten Energiequelle ist mit dem Gate-Anschluss des zweiten Transistors und der zweite Anschlusskontakt der zweiten Energiequelle mit dem Source-Anschluss des zweiten Transistors verschaltet.

Gemäß einer weiteren Ausführungsform ist zwischen der ersten Teilspannungsquelle und der zweiten Teilspannungsquelle eine Stromverteilerschicht angeordnet.

In einer Weiterbildung enthält oder besteht die erste Teilspannungsquelle und / oder die zweite Teilspannungsquelle einen Verbindungshalbleiter aus der Stoffgruppe der III-Arsenid oder der III-Phosphide.

In einer weiteren Ausführungsform umfasst die erste Teilspannungsquelle und die zweite Teilspannungsquelle eine GaAs-Verbindung oder besteht aus einer GaAs-Verbindung.

Ein erfindungsgemäßer Optokoppler weist eine Lichtempfangseinheit der vorbeschriebenen Art und einer Sendeeinheit, wobei die Sendeeinheit und die Empfangseinheit voneinander galvanisch getrennt und miteinander optisch gekoppelt und in einem gemeinsamen Gehäuse integriert sind.

Die Sendeeinheit umfasst mindestens eine erste Sendediode mit der ersten Lichtwellenlänge und eine zweite Sendediode mit der zweiten Lichtwellenlänge.

Es versteht sich, dass sofern die Photonenemission in dem Sendebaustein einer Modulation unterliegt, die Modulation eine modulierte Spannung verursacht, anders ausgedrückt, die Größe der erzeugten Energie verändert sich mit der Zeit.

Auch versteht es sich, dass mit dem Begriff in einem gemeinsamen Gehäuse insbesondere ein einziges Gehäuse verstanden wird, d.h. die Sendeeinheit und die Empfangseinheit weisen für sich genommen keine eigenen Gehäuse auf.

Es versteht sich, dass als Gehäuse insbesondere Vergussgehäuse verstanden sind. Derartige Gehäuse werden mittels eines sogenannten Moldprozesses hergestellt.

Bei einer stapelförmigen Ausgestaltung der Teilquellen der Lichtempfangseinheit muss von der Sendediode oder der Lichtquelle nur eine kleine Empfangsfläche, nämlich die Oberseite des Stapels der Lichtempfangseinheit beleuchtet werden.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Ansicht auf eine erste erfindungsgemäße Ausführungsform einer Lichtempfangseinheit,
- Figur 2: eine Ansicht auf eine Schaltbild mit Ersatzschalbild der ersten Ausführungsform einer Lichtempfangseinheit,
- Figur 3: eine Ansicht einer zweiten erfindungsgemäßen Ausführungsform einer Lichtempfangseinheit,
- Figur 4: eine Ansicht einer ersten erfindungsgemäßen Ausführungsform eines Optokopplers,
- Figur 5: eine Ansicht einer zweiten erfindungsgemäßen Ausführungsform eines Optokopplers,
- Figur 6: eine Tabelle zum Schaltverhalten.

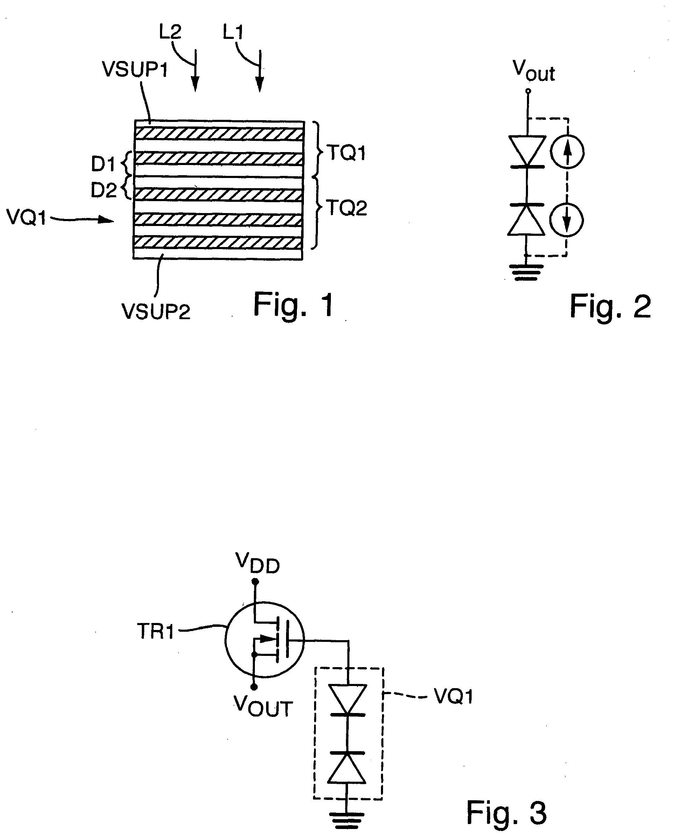

Die Abbildung der Figur 1 zeigt eine erste Ausführungsform einer Lichtempfangseinheit EM mit einem monolithischen Aufbau.

Die Lichtempfangseinheit weist eine erste Energiequelle VQ1, bestehend aus einer ersten Teilquelle TQ1 und einer zweiten Teilquelle TQ2 auf, wobei die erste Energiequelle VQ1 als Stromquelle oder als Spannungsquelle ausgebildet ist.

Jede der beiden Teilquelle TQ1, TQ2 weist mehrere Halbleiterschichten auf, wobei die Halbleiterschichten für jede Teilquelle TQ1, TQ2 stapelförmig angeordnet sind und aus einer GaAs-Verbindung bestehen.

Die Halbleiterschichten bilden Dioden aus, so dass die erste Teilquelle TQ1 mindestens eine erste Halbleiterdiode D1 und die zweite Teilquelle mindestens eine zweite Halbleiterdiode D2 umfasst.

Die erste Teilquelle TQ1 ist auf der zweiten Teilquelle TQ2 angeordnet. Beide Teilquellen TQ1 und TQ2 bilden einen einzigen Stapel aus und sind monolithisch integriert und miteinander in Serie verschaltet, wobei die erste Diode D1 der ersten Teilquellen TQ1 und die zweite Diode D2 der zweite Teilquelle TQ2 zueinander entgegengesetzt gepolt angeordnet und elektrisch verbunden sind.

Ein erster Anschluss VSUP1 ist an einer Oberseite der Teilquelle TQ1 und ein zweiter Anschluss VSUP2 an einer Unterseite der zweiten Teilquelle TQ2 als flächige Kontaktschicht angeordnet.

Die mindestens eine erste Halbleiterdiode D1 weist eine einer ersten Lichtwellenlänge L1 angepasste Absorptionskante und die mindestens eine zweite Halbleiterdiode D2 eine einer zweiten Lichtwellenlänge L2 angepasste Absorptionskante auf, so dass die erste Teilquelle TQ1 bei Bestrahlung mit der ersten Lichtwellenlänge L1 und die zweite Teilquelle TQ2 bei Bestrahlung mit der zweiten Lichtwellenlänge L2 elektrische Spannung erzeugen.

Die erste Lichtwellenlänge L1 unterscheidet sich von der zweiten Lichtwellenlänge L2 durch eine Differenzwellenlänge D, wobei die Differenzwellenlänge wenigstens 40 nm beträgt.

Einfallendes Licht trifft immer zuerst auf die Oberseite der ersten Energiequelle VQ1, vorliegend also auf die Oberseite der ersten Teilquelle TQ1 auf. Anschließend durchläuft es die erste Teilquelle TQ1 und die zweite Teilquelle TQ2. Es versteht sich, dass die erste Teilquelle TQ1 eine größere Bandlücke als die zweite Teilquelle TQ2 aufweist.

Durch die entgegengesetzte Polung der Halbleiterdioden D1 und D2 der beiden Teilquellen TQ1 und TQ2 weisen die erzeugten Spannung entgegengesetzte Vorzeichen auf, d.h. wenn die Lichtempfangseinheit gleichzeitig mit Licht der ersten Lichtwellenlänge L1 und mit Licht der zweiten Lichtwellenlänge L2 bestrahlt wird, kompensieren sich die Spannungen zumindest teilweise.

Während die kürzere Wellenlänge in der ersten Teilquelle TQ1 eine positive Spannung erzeugt, wird durch die längere Wellenlänge in der zweiten Teilquelle TQ2 eine negative Spannung erzeugt. Entsprechen sich die Spannungen dem Betrag nach, so beträgt die von der Lichtempfängereinheit EM erzeugte Spannung bei gleichzeitigem Einfall von Licht der ersten und zweiten Lichtwellenlänge L1 und L2 nahezu oder genau Null.

In einer booleschen Darstellung ausgedrückt, entspricht das Stromverhalten zwischen den beiden Anschlüssen VSUP1 und VSUP2 einer XOR Verknüpfung. Wenn Licht mit nur einer der beiden Lichtwellenlängen L1 oder L2 auf die Empfangseinheit EM trifft, lässt sich je nach Wellenlänge zwischen den beiden Anschlüssen VSUP1 und VSUP2 eine positive oder negative Spannung messen.

Fällt gleichzeitig Licht der Wellenlängen L1 und L2 ein, so kompensieren sich die von den Dioden D1 und D2 erzeugten Spannungen zumindest teilweise oder fast vollständig, so dass sich zwischen den beiden Anschlüssen VSUP1 und VSUP2 eine zumindest geringere negative oder positive Spannung oder deutlich geringere oder näherungsweise Null betragende Spannung einstellt. Fällt kein Licht mit einer Lichtwellenlänge L1 oder L2 ein, so beträgt die sich zwischen den beiden Anschlüssen VSUP1 und VSUP2 einstellende Spannung zumindest näherungsweise Null, da keine der Dioden D1 oder D2 eine relevante Spannung erzeugt.

In der Abbildung der Figur 2 ist schematisch ein Schaltbild mit Ersatzschaltbild einer Lichtempfangseinheit EM dargestellt. Der zweite Anschluss VSUP 2 ist geerdet, am ersten Anschluss VSUP1 wird ein Ausgangssignal Vout abgegriffen. Vorzugsweise wirken die Dioden als Spannungsquelle.

Die Abbildung der Figur 3 zeigt eine schematische Ansicht einer weiteren Ausführungsform einer erfindungsgemäßen Lichtempfangseinheit EM. Im Folgenden werden nur die Unterschiede zu den Figuren 1 und 2 erläutert.

Die Lichtempfangseinheit EM weist einen selbstsperrenden ersten Transistor TR1 auf, wobei der zweite Anschluss VSUP1 der ersten Energiequelle VQ1 geerdet ist und der zweite Anschluss VSUP2 mit dem Gate-Anschluss G des ersten Transistors TR1 verschaltet ist.

An dem Drain-Anschluss D des ersten Transistors TR1 liegt eine Versorgungsspannung VDD an und an dem Source- Anschluss S des Transistors wird das Ausgangssignal Vout abgegriffen.

Die erste Energiequelle schaltet den Transistor TR1, so dass das Ausgangssignal Vout bildet eine XOR Verknüpfung hinsichtlich des Einfalls von Licht der Wellenlängen L1 und L2 aus.

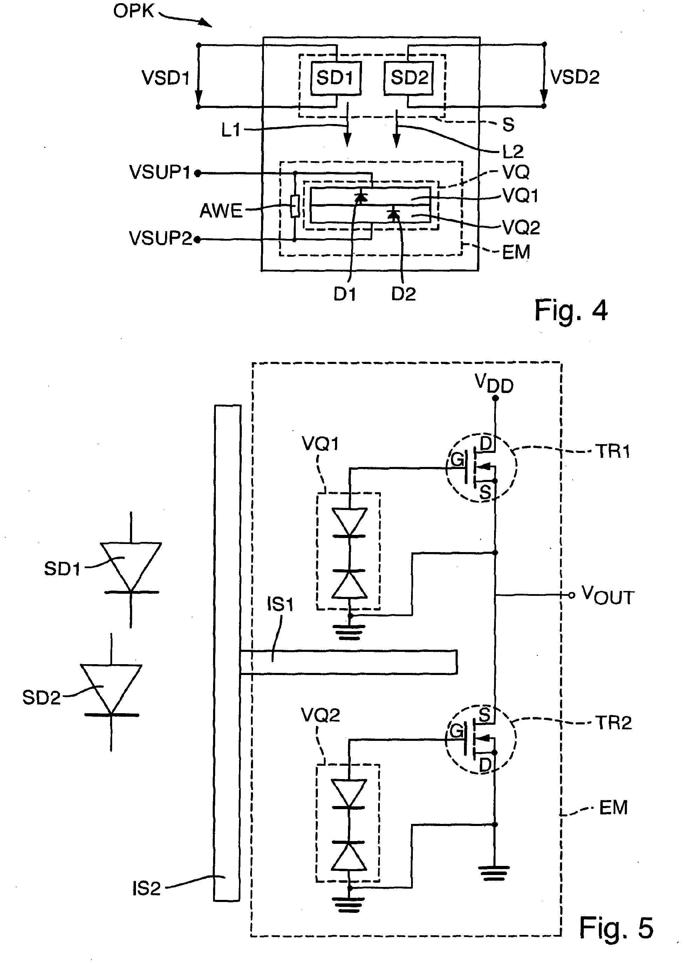

Die Abbildung der Figur 4 zeigt eine erste Ausführungsform eines erfindungsgemäßen Optokopplers OPK mit einer Lichtempfangseinheit EM der vorbeschriebenen Art und einer Sendeeinheit S. Im Folgenden werden nur die Unterschiede zu der Abbildung der Figur 1 erläutert.

Es versteht sich, dass der Optokoppler OPK gehäust ist, d.h. die genannten Bauelemente sind in dem gemeinsamen Gehäuse integriert. Sofern Senderbaustein S einen modulierten Photonenstrom aussendet, wird auch in dem Empfängerbaustein EM die Spannung und der Strom moduliert.

Der Sendebaustein S umfasst eine erste Sendediode SD1 und eine zweite Sendediode SD2. Die erste Sendediode SD1 weist die auf die mindestens eine erste Diode D1 der Lichtempfangseinheit EM abgestimmte erste Lichtwellenlänge L1 auf.

Die zweite Sendediode SD2 weist die auf die mindestens eine zweite Diode D2 der Lichtempfangseinheit EM abgestimmte zweite Lichtwellenlänge L2 auf. Die erste Sendediode SD1 weist zwei Anschlusskontakte auf, wobei an den beiden Anschlusskontakten eine erste Versorgungsspannung VDS1 anliegt.

Die zweite Sendediode SD2 weist ebenfalls zwei Anschlusskontakte auf, wobei an den beiden Anschlusskontakten eine zweite Versorgungsspannung VDS2 anliegt.

Die Lichtempfangseinheit EM weist eine Auswerteeinheit AWE auf, die parallel zu der ersten Energiequelle VQ1 verschaltet ist.

In der Abbildung der Figur 5 ist eine weitere Ausführungsform einer vorteilhaften Weiterbildung eines erfindungsgemäßen Optokopplers OPK dargestellt. Im Folgenden werden nur die Unterschiede zu der Abbildung der Figur 3 und 4 erläutert.

Die Empfangseinheit EM weist neben der ersten Energiequelle VQ1 eine zweite Energiequelle VQ2 auf, wobei die zweite Energiequelle VQ2 mit der ersten Energiequelle VQ1 baugleich ausgebildet ist.

Zwischen der ersten Energiequelle VQ1 und der zweiten Energiequelle VQ2 ist eine nicht elektrisch leitfähige erste Isolation IS1 angeordnet. Die Empfangseinheit EM ist gegenüber den beiden Sendedioden SD1 und SD2 mittels einer nicht elektrisch leitfähigen, optisch transparenten zweiten Isolation IS2 getrennt.

Die Energiequellen VQ1 und VQ2 sind entsprechend dem in Figur 3 dargestellten Ausführungsbeispiel mit einem ersten selbstsperrenden Transistor TR1 bzw. einem zweiten selbstsperrenden Transistor TR2 verschaltet, wobei der erste Transistor TR1 ein n-Kanal Transistor und der zweite Transistor TR2 ein p-Kanal Transistor ist.

Die Versorgungsspannung VDD liegt am Drain-Anschluss D des ersten Transistors TR1 an, der Drain-Anschluss D des zweiten Transistors TR2 ist geerdet und die Source-Anschlüsse S der beiden Transistoren TR1 und TR2 sind kurzgeschlossen. Das Ausgangssignal Vout wird zwischen den Source-Anschlüssen S der beiden Transistoren TR1 und TR2 abgegriffen.

Der Einfall von Licht nur der ersten Sendediode SD1 erzeugt jeweils eine positive Spannung in den ersten Dioden D1 der beiden Energiequellen VQ1 und VQ2, wodurch der n-Kanal Transistor TR1 leitet, während der p-Kanal Transistor sperrt. Das Ausgangssignal Vout entspricht der Versorgungsspannung VDD.

Fällt nur Licht der zweiten Sendediode SD2 ein, so erzeugen die zweiten Dioden D2 der beiden Energiequellen VQ1 und VQ2 jeweils eine negative Spannung.

Der n-Kanal Transistor TR1 sperrt, während der p-Kanal Transistor TR2 leitet. Das Ausgangssignal entspricht der in der zweiten Diode D2 der zweiten Energiequelle VQ2 erzeugten negativen Spannung.

Fällt gleichzeitig Licht der ersten und zweiten Sendediode SD1 und SD2 ein, so kompensieren sich jeweils die in den ersten Dioden D1 und den zweiten Dioden D2 der beiden Energiequellen VQ1 und VQ2 erzeugten Spannungen jeweils, so dass beide Transistoren TR1 und TR2 sperren und das Ausgangssignal Vout Null beträgt.

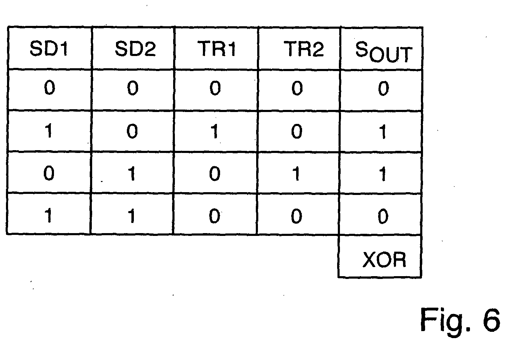

Die Tabelle der Figur 6 zeigt den Zusammenhang zwischen dem Lichteinfall des Lichts der beiden Sendedioden SD1 und SD2, dem Schaltzustand der beiden Transistoren TR1 und TR2 und einem aus dem Ausgangssignal Vout gewonnen Schaltsignal Sout.

## Patentansprüche

1. Lichtempfangseinheit (EM) aufweisend eine erste Energiequelle (VQ1), wobei
- die erste Energiequelle (VQ1) zwei, jeweils als Stromquelle oder als Spannungsquelle ausgebildeten Teilquellen (TQ1, TQ2) aufweist,
- die erste Energiequelle (VQ1) lediglich einen ersten elektrischen Anschlusskontakt (VSUP1) und einen zweiten elektrischen Anschlusskontakt (VSUP2) aufweist,
- der erster Anschlusskontakt (VSUP1) an der Oberseite der ersten Teilquelle (TQ1) und der zweiter Anschlusskontakt (VSUP2) an der Unterseite der zweiten Teilquelle (TQ1) ausgebildet ist,
- die erste Teilquelle (TQ1) mindestens eine erste Halbleiterdiode (D1) aufweist und die zweite Teilquelle (TQ2) mindestens eine zweite Halbleiterdiode (D2) aufweist,
- die erste Halbleiterdiode (D1) eine an eine erste Lichtwellenlänge (L1) angepasste Absorptionskante und die zweite Halbleiterdiode (D2) eine an eine zweite Lichtwellenlänge (L2) angepasste Absorptionskante aufweist, so dass die erste Teilquelle (TQ1) bei Bestrahlung mit der ersten Lichtwellenlänge (L1) und die zweite Teilquelle (TQ2) bei Bestrahlung mit der zweiten Lichtwellenlänge (L2) elektrische Spannung erzeugen,
- die erste Lichtwellenlänge (L1) von der zweiten Lichtwellenlänge (L2) um eine Differenzwellenlänge (D) verschieden ist,
**dadurch gekennzeichnet, dass**
- die erste Halbleiterdiode (D1) zu der zweiten Halbleiterdiode (D2) entgegengesetzt gepolt in Reihe geschaltet ist, so dass sich die von der ersten Halbleiterdiode (D1) und die von der zweiten Halbleiterdiode (D2) erzeugten Spannungen zumindest teilweise kompensieren.

2. Lichtempfangseinheit (EM) nach Anspruch 1, **dadurch gekennzeichnet, dass** jede Teilquelle (TQ1, TQ2) mehrere Halbleiterschichten aufweist, die Halbleiterschichten für jede Teilquelle (TQ1, TQ2) stapelförmig angeordnet sind, jede Teilquelle (TQ1, TQ2) eine Oberseite und eine Unterseite aufweist und die Unterseite der ersten Teilquelle (TQ1) auf der Oberseite der zweiten Teilquelle (TQ2) angeordnet ist und die erste Teilspannungsquelle (TQ1) und die zweite Teilspannungsquelle (TQ2) monolithisch integriert sind, so dass die beiden Teilquellen (TQ1, TQ2) einen gemeinsamen Stapel mit einer Vorderseite und einer Rückseite ausbilden.

3. Lichtempfangseinheit (EM) nach Anspruch 1 oder 2, **dadurch gekennzeichnet, dass** die Lichtempfangseinheit einen ersten selbstsperrenden Transistor (TR1) aufweist, wobei der erste Anschlusskontakt (VSUP1) der ersten Energiequelle (VQ1) mit dem Gate-Anschluss (G) des ersten Transistors (TR1) und der zweite Anschlusskontakt (VSUP2) der ersten Energiequelle (VQ1) mit dem Source-Anschluss (S) des ersten Transistors (TR1) verschaltet ist.

4. Lichtempfangseinheit (EM) nach einem der Ansprüche 1 bis 3, **dadurch gekennzeichnet, dass** die Lichtempfangseinheit eine zweite Energiequelle (VQ2) aufweist, wobei die zweite Energiequelle (VQ2) im Wesentlichen baugleich mit der der ersten Energiequelle (VQ1) ausgebildet ist.

5. Lichtempfangseinheit (EM) nach Anspruch 4, **dadurch gekennzeichnet, dass** zwischen der ersten Energiequelle (VQ1) und der zweiten Energiequelle (VQ2) eine elektrisch isolierende Barriere angeordnet ist.

6. Lichtempfangseinheit (EM) nach Anspruch 4 oder 5, **dadurch gekennzeichnet, dass** die Lichtempfangseinheit (EM) einen ersten selbstsperrenden Transistor (TR1) und einen zweiten selbstsperrenden Transistor aufweist, wobei
- der erste Transistor (TR1) als n-Kanal-Transistor ausgebildet ist und der zweite Transistor (TR2) als p-Kanal Transistor ausgebildet ist,
- der erste Anschlusskontakt (VSUP1) der ersten Energiequelle (VQ1) mit dem Gate-Anschluss (G) des ersten Transistors (TR1) und der zweite Anschlusskontakt (VSUP2) der ersten Energiequelle (VQ1) mit dem Source-Anschluss (S) des ersten Transistors (TR1) verschaltet ist und
- der erste Anschlusskontakt (VSUP1) der zweiten Energiequelle (VQ2) mit dem Gate-Anschluss (G) des zweiten Transistors (TR2) und der zweite Anschlusskontakt (VSUP2) der zweiten Energiequelle (VQ2) mit dem Source-Anschluss (S) des zweiten Transistors (TR2) verschaltet ist.

7. Lichtempfangseinheit (EM) nach einem der Ansprüche 1 bis 6, **dadurch gekennzeichnet, dass** zwischen der ersten Teilspannungsquelle (TQ1) und der zweiten Teilspannungsquelle (TQ2) eine Stromverteilerschicht (SV1) angeordnet ist.

8. Lichtempfangseinheit (EM) nach einem der Ansprüche 1 bis 7, **dadurch gekennzeichnet, dass** die erste Teilspannungsquelle (TQ1) und / oder die zweite Teilspannungsquelle (TQ2) einen Verbindungshalbleiter aus der Stoffgruppe der III-Arsenid oder der III-Phosphide enthält oder aus besteht oder die erste Teilspannungsquelle (TQ1) und / oder die zweite Teilspannungsquelle (TQ2) eine GaAs-Verbindung umfasst oder aus einer GaAs-Verbindung besteht.

9. Optokoppler (OPK) mit einer Lichtempfangseinheit (EM) nach einem der Ansprüche 1 bis 8 und einer Sendeeinheit (S), wobei
- die Sendeeinheit (S) und die Empfangseinheit (EM) voneinander galvanisch getrennt und miteinander optisch gekoppelt und in einem gemeinsamen Gehäuse integriert sind,
- die Sendeeinheit (S) mindestens eine erste Sendediode (SD1) mit der ersten Lichtwellenlänge (L1) und eine zweite Sendediode (SD2) mit der zweiten Lichtwellenlänge (L2) aufweist.

## Claims

1. Light-receiving unit (EM) comprising a first energy source (VQ1),
wherein
- the first energy source (VQ1) comprises two sub-sources (TQ1, TQ2) each configured as a current source or voltage source,
- the first energy source (VQ1) has merely a first electrical terminal contact (VSUP1) and a second electrical terminal contact (VSUP2),
- the first terminal contact (VSUP1) is formed at the upper side of the first sub-source (TQ1) and the second terminal contact (VSUP2) at the lower side of the second sub-source (TQ1),
- the first sub-source (TQ1) comprises at least one first semiconductor diode (D1) and the second sub-source (TQ2) comprises at least one second semiconductor diode (D2),
- the first semiconductor diode (D1) has an absorption edge adapted to a first light wavelength (L1) and the second semiconductor diode (D2) has an absorption edge adapted to a second light wavelength (L2) so that the first sub-source (TQ1) when irradiated by the first light wavelength (L1) and the second sub-source (TQ2) when irradiated by the second light wavelength (L2) generate electrical voltage,
- the first light wavelength (L1) differs from the second light wavelength (L2) by a difference wavelength (D),
**characterised in that**
- the first semiconductor diode (D1) is connected in series with the second semiconductor diode (D2) with opposite poling so that the voltages generated by the first semiconductor diode (D1) and the voltages generated by the second semiconductor diode (D2) provide at least partial compensation.

2. Light-receiving unit (EM) according to claim 1, **characterised in that** each sub-source (TQ1, TQ2) has a plurality of semiconductor layers, the semiconductor layers for each sub-source (TQ1, TQ2) are arranged to be stack-shaped, each sub-source (TQ1, TQ2) has an upper side and a lower side and the lower side of the first sub-source (TQ1) is arranged on the upper side of the second sub-source (TQ2) and the first voltage sub-source (TQ1) and the second voltage sub-source (TQ2) are monolithically integrated so that the two sub-sources (TQ1, TQ2) form a common stack with a front side and a rear side.

3. Light-receiving unit (EM) according to claim 1 or 2, **characterised in that** the light-receiving unit comprises a first enhancement-type transistor (TR1), wherein the first terminal contact (VSUP1) of the first energy source (VQ1) is connected with the gate terminal (G) of the first transistor (TR1) and the second terminal contact (VSUP2) of the first energy source (VQ1) is connected with the source terminal (S) of the first transistor (TR1).

4. Light-receiving unit (EM) according to any one of claims 1 to 3, **characterised in that** the light-receiving unit comprises a second energy source (VQ2), wherein the second energy source (VQ2) has substantially the same construction as that of the first energy source (VQ1).

5. Light-receiving unit (EM) according to claim 4, **characterised in that** an electrically insulating barrier is arranged between the first energy source (VQ1) and the second energy source (VQ2).

6. Light-receiving unit (EM) according to claim 4 or 5, **characterised in that** the light-receiving unit (EM) comprises a first enhancement-type transistor (TR1) and a second enhancement-type transistor, wherein
- the first transistor (TR1) is constructed as an n-channel transistor and the second transistor (TR2) is constructed as a p-channel transistor,
- the first terminal contact (VSUP1) of the first energy source (VQ1) is connected with the gate terminal (G) of the first transistor (TR1) and the second terminal contact (VSUP2) of the first energy source (VQ1) is connected with the source terminal (S) of the first transistor (TR1) and
- the first terminal contact (VSUP1) of the second energy source (VQ2) is connected with the gate terminal (G) of the second transistor (TR2) and the second terminal contact (VSUP2) of the second energy source (VQ2) is connected with the source terminal (S) of the second transistor (TR2).

7. Light-receiving unit (EM) according to any one of claims 1 to 6, **characterised in that** a current distributor layer (SV1) is arranged between the first voltage sub-source (TQ1) and the second voltage sub-source (TQ2).

8. Light-receiving unit (EM) according to any one of claims 1 to 7, **characterised in that** the first voltage sub-source (TQ1) and/or the second voltage sub-source (TQ2) contains or consists of a connecting semiconductor of the material group III arsenide or III phosphide or the first voltage sub-source (TQ1) and/or the second voltage sub-source (TQ2) comprises or comprise a GaAs compound or consists or consist of a GaAs compound.

9. Optocoupler (OPK) with a light-receiving unit (EM) according to any one of claims 1 to 8 and a transmitting unit (S), wherein
- the transmitting unit (S) and the receiving unit (EM) are insulated from one another and optically coupled together and integrated in a common housing,
- the transmitting unit (S) comprises at least one first transmitting diode (SD1) with the first light wavelength (L1) and a second transmitting diode (SD2) with the second light wavelength (L2).

## Revendications

1. Unité photoréceptrice (EM) comportant une première source d'énergie (VQ1), dans laquelle
- la première source d'énergie (VQ1) comporte deux sources partielles (TQ1, TQ2) configurées chacune comme une source de courant ou comme une source de tension,
- la première source d'énergie (VQ1) comporte uniquement un premier contact de raccordement électrique (VSUP1) et un deuxième contact de raccordement électrique (VSUP2),
- le premier contact de raccordement électrique (VSUP1) est configuré sur la face supérieure de la première source partielle (TQ1) et le deuxième contact de raccordement électrique (VSUP2) sur la face inférieure de la deuxième source partielle (TQ1),
- la première source partielle (TQ1) comporte au moins une première diode à semi-conducteurs (D1) et deuxième source partielle (TQ2) comporte au moins une deuxième diode à semi-conducteurs (D2),
- la première diode à semi-conducteurs (D1) présente un bord d'absorption adapté à une première longueur d'onde lumineuse (L1) et la deuxième diode à semi-conducteurs (D2) un bord d'absorption adapté à une deuxième longueur d'onde lumineuse (L2), de sorte que la première source partielle (TQ1) génère une tension électrique lorsqu'elle est irradiée avec la première longueur d'onde lumineuse (L1) et la deuxième source partielle (TQ2) lorsqu'elle est irradiée avec la deuxième longueur d'onde lumineuse (L2), et
- la première longueur d'onde lumineuse (L1) diffère de la deuxième longueur d'onde lumineuse (L2) d'une longueur d'onde différentielle (D),
**caractérisée en ce que**
- la première diode à semi-conducteurs (D1) est connectée en série avec une polarité opposée à celle de la deuxième diode à semi-conducteurs (D2), de sorte que les tensions générées par la première diode à semi-conducteurs (D1) et la deuxième diode à semi-conducteurs (D2) se compensent au moins partiellement.

2. Unité photoréceptrice (EM) selon la revendication 1, **caractérisée en ce que** chaque source partielle (TQ1, TQ2) comporte plusieurs couches de semi-conducteurs, les couches de semi-conducteurs pour chaque source partielle sont disposées en pile, chaque source partielle (TQ1, TQ2) présente une face supérieure et une face inférieure, la face inférieure de la première source partielle (TQ1) étant disposée sur la face supérieure de la deuxième source partielle (TQ2), et la première source de tension partielle (TQ1) et la deuxième source de tension partielle (TQ2) sont intégrées de façon monolithique de sorte que les deux sources partielles (TQ1, TQ2) forment une pile commune avec une face avant et une face arrière.

3. Unité photoréceptrice (EM) selon la revendication 1 ou 2, **caractérisée en ce que** cette unité photoréceptrice comporte un premier transistor autobloquant (TR1), le premier contact de raccordement (VSUP1) de la première source d'énergie (VQ1) étant interconnecté avec la borne de grille (G) du premier transistor (TR1) et le deuxième contact de raccordement (VSUP2) de la première source d'énergie (VQ1) avec la borne de source (S) du premier transistor (TR1).

4. Unité photoréceptrice (EM) selon une des revendications 1 à 3, **caractérisée en ce que** cette unité photoréceptrice comporte une deuxième source d'énergie (VQ2), laquelle deuxième source d'énergie (VQ2) est configurée de façon sensiblement identique à la première source d'énergie (VQ1).

5. Unité photoréceptrice (EM) selon la revendication 4, **caractérisée en ce qu'**entre la première source d'énergie (VQ1) et la deuxième source d'énergie (VQ2) est disposée une barrière isolante électriquement.

6. Unité photoréceptrice (EM) selon la revendication 4 ou 5, **caractérisée en ce que** cette unité photoréceptrice (EM) comporte un premier transistor autobloquant (TR1) et un deuxième transistor autobloquant (TR2), dans lequel
- le premier transistor (TR1) est configuré comme un transistor à canal n et le deuxième transistor (TR2) est configuré comme un transistor à canal p,
- le premier contact de raccordement (VSUP1) de la première source d'énergie (VQ1) est interconnecté avec la borne de grille (G) du premier transistor (TR1) et le deuxième contact de raccordement (VSUP2) de la première source d'énergie (VQ1) avec la borne de source (S) du premier transistor (TR1) et
- le premier contact de raccordement (VSUP1) de la deuxième source d'énergie (VQ2) est interconnecté avec la borne de grille (G) du deuxième transistor (TR2) et le deuxième contact de raccordement (VSUP2) de la deuxième source d'énergie (VQ2) avec la borne de source (S) du deuxième transistor (TR2).

7. Unité photoréceptrice (EM) selon une des revendications 1 à 6, **caractérisée en ce qu'**entre la première source de tension partielle (TQ1) et la deuxième source de tension partielle (TQ2) est disposée une couche de distribution de courant (SV1).

8. Unité photoréceptrice (EM) selon une des revendications 1 à 7, **caractérisée en ce que** la première source de tension partielle (TQ1) et/ou la deuxième source de tension partielle (TQ2) contiennent ou sont constituées par un semi-conducteur composé du groupe de l'arséniure III ou des phosphures III et/ou que la deuxième source de tension partielle (TQ2) comprend une liaison GaAs ou est constituée par une liaison GaAs.

9. Optocoupleur (OPK) avec une unité photoréceptrice (EM) selon une des revendications 1 à 8 et une unité émettrice (S), dans lequel
- l'unité émettrice (S) et l'unité réceptrice (EM) sont isolées galvaniquement l'une de l'autre et couplées optiquement entre elles et intégrées dans un boîtier commun et
- l'unité émettrice (S) comporte au moins une première diode émettrice (SD1) dotée de la première longueur d'onde lumineuse (L1) et une deuxième diode émettrice (SD2) dotée de la deuxième longueur d'onde lumineuse (L2).
